# EUROPÄISCHE PATENTSCHRIFT

(11) **EP 0 952 166 B1**
(45) Veröffentlichungstag und Bekanntmachung des Hinweises auf die Patenterteilung: **25.06.2003**
(21) Anmeldenummer: 99107109.3
(22) Anmeldetag: 12.04.1999
(51) Int. Cl.: C08F 222/16, C08F 230/08, C08F 230/04, C08F 222/20, G03F 7/039

(54) **Filmbildende Polymere**
Filmforming polymers
Polymères filmogènes

(30) Priorität: 24.04.1998 DE 19818446
(43) Veröffentlichungstag der Anmeldung: 27.10.1999
(73) Patentinhaber: Infineon Technologies AG, 81669 München (DE)
(72) Erfinder: Hien, Stefan Dr., 91058 Erlangen (DE); Sebald, Michael Dr., 91085 Weisendorf (DE)
(74) Vertreter: Müller - Hoffmann & Partner

(56) Entgegenhaltungen:
- EP-A- 0 342 493
- EP-A- 0 388 484
- EP-A- 0 412 385
- EP-A- 0 841 353
- WO-A-96/24621
- US-A- 5 237 024
- DATABASE WPI Section Ch, Week 198736 Derwent Publications Ltd., London, GB; Class A14, AN 1987-252533 XP002004078 & JP 62 172342 A (NIPPON TELEGRAPH & TELEPHONE CORP), 29. Juli 1987 (1987-07-29)

## Beschreibung

Die Erfindung betrifft neue filmbildende, funktionalisierte Polymere mit 1,2-Dicarbonsäurehalbester-Gruppierungen.

Filmbildende, funktionalisierte Polymere, die bereits seit langem bekannt sind, werden zur Beschichtung von Metallen, Papier und Textilien sowie in der Kosmetikindustie, beispielsweise in Haarsprays, eingesetzt. Auch in der pharmazeutischen Industrie finden derartige Polymere Verwendung, beispielsweise zur Verkapselung oder zur Immobilisierung von Wirkstoffen. Elektronische Anwendungen finden sich beispielsweise auf dem Gebiet von NLO-Polymeren, d.h. nichtlinear-optisch aktiven Polymeren, und von Photolacken (Photoresists). Im letzteren Fall werden Mischungen aus den Polymeren und photoaktiven, d.h. strahlungsempfindlichen Komponenten beispielsweise zur Strukturierung von Halbleiterbauelementen eingesetzt. Ein wichtiges Erfordernis ist hierbei eine hohe Transparenz der Polymeren bei der Belichtungswellenlänge. Ähnliche Ansprüche werden auch an Polymere gestellt, die in der Druckplatten-industrie oder bei der Photohärtung zum Einsatz gelangen.

Die Herstellung von Halbestern (Monoestern) von Maleinsäure-Copolymeren und deren Verwendung in Photolacken ist beispielsweise aus der WO 96/24621 bekannt. Aus der WO 97/14079 ist ebenfalls die Verwendung von Polymeren mit vicinalen Dicarbonsäuremonoester-Gruppierungen in Photoresists bekannt. In der WO 89/07786 ist die Alkoholyse von Copolymeren aus Maleinsäureanhydrid und cycloaliphatischen Kohlenwasserstoffen beschrieben.

Aufgabe der Erfindung ist es, neue filmbildende, funktionalisierte Polymere mit 1,2-Dicarbonsäurehalbester-Gruppierungen bereitzustellen, welche für unterschiedliche Anwendungen geeignet sind und insbesondere in Photoresists Verwendung finden können.

Dies wird erfindungsgemäß durch Polymere erreicht, die einen säurelabilen, hydrolysestabilen Polymerbaustein (A) folgender Struktur: 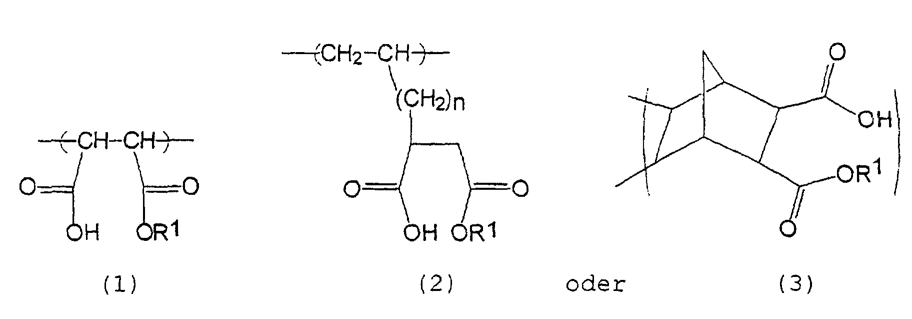 mit einem Anteil von 1 bis 99 Mol-% und einen thermisch stabilen Polymerbaustein (B) folgender Struktur: 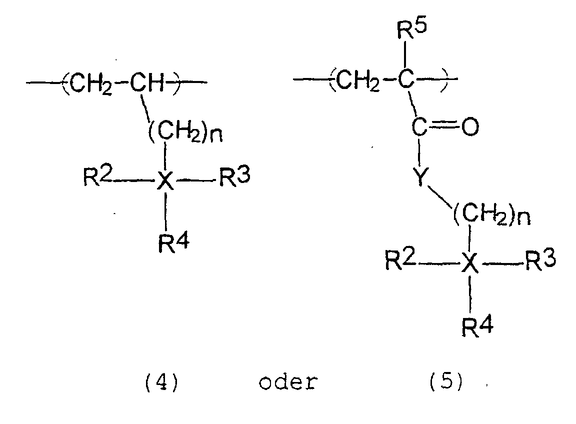 mit einem Anteil von 99 bis 1 Mol-% aufweisen,
wobei folgendes gilt:
n = 0, 1, 2 oder 3,
R¹ ist ein über ein tertiäres C-Atom an das O-Atom gebundener Kohlenwasserstoffrest mit insgesamt 4 bis 10 C-Atomen oder ein 2-Tetrahydrofuranyl- oder 2-Tetrahydropyranylrest,
R², R³ und R⁴ sind - unabhängig voneinander - C₁- bis C₆-Alkyl oder C₁- bis C₆-Alkoxy, C₆- bis C₁₈-Aryl oder C₆- bis C₁₈-Aryloxy oder Aralkyl mit einer C₆- bis C₁₈-Arylgruppe und einem C₁- bis C₄-Alkylenrest,
R⁵ ist H oder C₁- bis C₆-Alkyl,
X ist Si oder Sn,
Y ist 0 oder NH.

Die Anteile an den Polymerbausteinen (A) und (B) ergänzen sich zu 100 Mol-%. Der Anteil des Polymers am Baustein (A) beträgt vorzugsweise 5 bis 50 Mol-%. Der Rest R¹ kann beispielsweise ein tert.-Butylrest -C(CH₃)₃, ein tert.-Pentylrest -C(CH₃)₂-C₂H₅ oder ein 1-Adamantylrest (-C₁₀H₁₅) sein. Ein wesentliches Merkmal des Polymerbausteins (B) ist im übrigen dessen metallischer Bestandteil, d. h. das Vorhandensein von Silicium Si bzw. Zinn Sn.

Das Polymer nach der Erfindung kann - entsprechend den Struktureinheiten (1) bzw. (2) und (3) - ketten- oder seitenständige 1,2-Dicarbonsäurehalbester-Gruppierungen aufweisen. Ein Polymer aus den Bausteinen (A) und (B) mit kettenständigen Gruppierungen kann beispielsweise durch Umsetzung eines Maleinsäureanhydrid-Copolymers mit tert.-Butanol hergestellt werden. Die 1,2-Dicarbonsäure-mono-tert.-butylester-Gruppierungen können aber auch durch Homo- oder Copolymerisation von Fumarsäure- oder Maleinsäure-mono-tert.-butylester in das Polymer eingeführt werden.

Polymere mit seitenständigen 1,2-Dicarbonsäurehalbester-Gruppierungen, d.h. mit Gruppierungen, die nicht direkt an die Polymerhauptkette gebunden sind, sondern außerhalb der Hauptkette liegen, können beispielsweise durch Homopolymerisation von bzw. Copolymerisation mit 1-Alkyl-2-(3-alkylenbernsteinsäureanhydrid)-ethylen und anschließende Umsetzung mit tert.-Butanol oder durch Homopolymerisation von 1-Alkyl-2-(3-alkylen-bernsteinsäure-mono-tert.-butylester)-ethylen erhalten werden. Im Falle der Struktureinheit (3) sind die 1,2-Dicarbonsäurehalbester-Gruppierungen im übrigen über einen Norbornylrest an die Polymerhauptkette gebunden.

Zur Herstellung von Polymeren nach der Erfindung werden im allgemeinen Monomere für die Bausteine (A) mit elektronenreichen Monomeren für die Bausteine (B) copolymerisiert. Durch die Copolymerisation werden einerseits hohe Polymerausbeuten erreicht, und andererseits können auf diese Weise die physikalischen Eigenschaften der Polymeren eingestellt werden. So kann beispielsweise ein bestimmter Si-Gehalt realisiert werden.

Die Polymeren nach der Erfindung weisen - neben dem Baustein (B) - vorteilhaft einen weiteren thermisch stabilen Polymerbaustein (C) folgender Struktur mit einem Anteil von 1 bis 50 Mol-% auf: 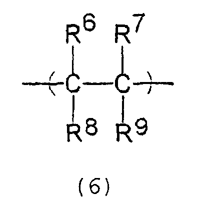 wobei folgendes gilt:
R⁶, R⁷, R⁸ und R⁹ sind - unabhängig voneinander - H, C₁- bis C₆-Alkyl, C₆- bis C₁₈-Aryl, Halogen, CN, Methoxyphenyl oder ein Rest folgender Struktur:

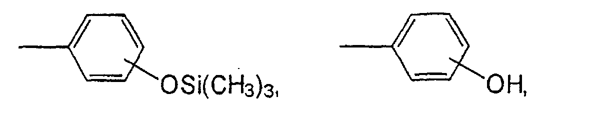

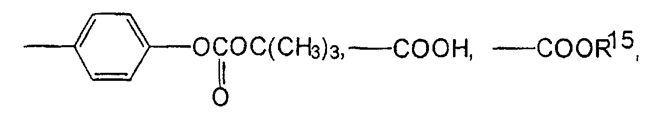

   ―CH₂Si(CH₃)₃, ―Si(CH₃)₃, ―Si(OCH₃)₃
wobei R¹⁵ die Bedeutung H, C₁- bis C₆-Alkyl, C₆- bis C₁₈-Aryl, CH₂=CH- (Vinyl), CH₂=CH-CH₂- (Allyl) oder CH₂=CH-CO- hat.

Polymere mit den Bausteinen (A) und (B) bzw. (A), (B) und (C) können vorteilhaft zusätzlich einen weiteren Polymerbaustein (D) folgender Struktur aufweisen: 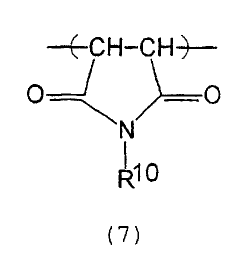 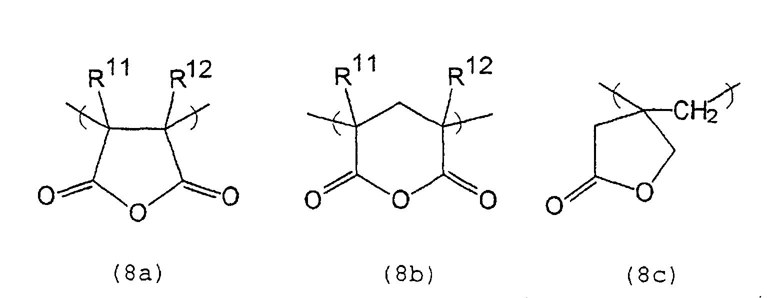 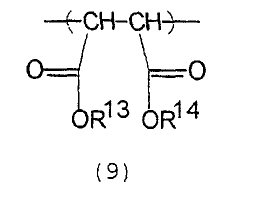 wobei folgendes gilt:
R¹⁰ ist H, C₁- bis C₆-Alkyl, C₂- bis C₆-Alkenyl, C₆- bis C₁₈-Aryl, Halogen oder halogensubstituiertes C₁- bis C₆-Alkyl,
R¹¹ und R¹² sind - unabhängig voneinander - lineares C₁- bis C₁₈-Alkyl,
R¹³ und R¹⁴ sind - unabhängig voneinander - lineares C₁- bis C₁₈-Alkyl oder tert.-Butyl.

Der Polymerbaustein (D) besitzt reaktive Gruppen, die eine Nachbehandlung des Polymers erlauben. Dazu beinhaltet (D) entweder eine Imidgruppierung (Struktureinheit 7) oder eine Anhydrid- bzw. Lactongruppierung (Struktureinheit 8) oder eine Dicarbonsäuredialkylestergruppierung (Struktureinheit 9). Der Anhydridgruppierung liegt Bernsteinsäureanhydrid (Struktureinheit 8a) oder Glutarsäureanhydrid (Struktureinheit 8b) zugrunde, der Lactongruppierung γ-Butyrolacton (Struktureinheit 8c).

Der Anteil des Bausteins (D) beträgt 1 bis 50 Mol-%. Die Anteile der Polymerbausteine - (A)+(B)+(C), (A)+(B)+(D) bzw. (A)+(B)+(C)+(D) - ergänzen sich jeweils zu 100 Mol-%. Durch die Auswahl der entsprechenden Monomerverhältnisse können die Polymereigenschaften, wie Glasübergangstemperatur und Löslichkeit, gezielt eingestellt werden.

Anhand von Ausführungsbeispielen soll die Erfindung noch näher erläutert werden (GT = Gewichtsteile).

### Beispiel 1

### Herstellung eines Copolymers mit 1,2-Dicarbonsäure-monotert.-butylester-Gruppierungen

11,3 GT tert.-Butyl-trimethylsilyl-fumarat (hergestellt durch Umsetzung von tert.-Butyl-fumarat mit Hexamethyldisilazan oder mit Trimethylchlorsilan analog J. Polym. Sci., Part A: Polym. Chem. Vol. 25 (1987), Seiten 979 bis 986) werden unter einer Inertgasatmosphäre zusammen mit 5,7 GT Allyltrimethylsilan und 0,08 GT Azobisisobutyronitril in 15 GT trockenem Ethylacetat gelöst, dann wird zum Sieden erhitzt. Nach 24 Stunden wird mit 1 GT Wasser versetzt und weitere 3 Stunden zum Sieden erhitzt; nachfolgend wird auf Raumtemperatur abgekühlt. Durch Eintropfen der Polymerlösung in Petrolether (Siedebereich 60 bis 80°C), anschließende Filtration und Trocknung bei 50°C für 24 Stunden im Vakuum werden 10 GT farbloses Polymerpulver erhalten.

### Beispiel 2

Herstellung eines Copolymers mit 1,2-Dicarbonsäure-monotert.-butylester-Gruppierungen

8 GT tert.-Butyl-fumarat (Herstellung analog J. Heterocyclic Chem. Vol. 32 (1995), Seiten 1309 bis 1315) werden zusammen mit 5,7 GT Allyltrimethylsilan und 0,08 GT Azobisisobutyronitril in 15 GT Ethylacetat gelöst. Die Lösung wird 24 Stunden zum Sieden erhitzt und danach auf Raumtemperatur abgekühlt. Durch Eintropfen der Polymerlösung in Petrolether (Siedebereich 60 bis 80°C), anschließende Filtration und Trocknung bei 50°C für 24 Stunden im Vakuum werden 10 GT farbloses Polymerpulver erhalten.

### Beispiel 3

### Herstellung eines Terpolymers mit 1,2-Dicarbonsäure-monotert.-butylester-Gruppierungen

6 GT tert.-Butyl-fumarat (Herstellung analog J. Heterocyclic Chem. Vol. 32 (1995), Seiten 1309 bis 1315) und 2,5 GT 1-Hexen werden zusammen mit 5,7 GT Allyltrimethylsilan und 0,08 GT Azobisisobutyronitril in 15 GT Ethylacetat gelöst. Die Lösung wird 24 Stunden zum Sieden erhitzt und danach auf Raumtemperatur abgekühlt. Durch Eintropfen der Polymerlösung in Petrolether (Siedebereich 60 bis 80°C), anschließende Filtration und Trocknung bei 50°C für 24 Stunden im Vakuum werden 9,5 GT farbloses Polymerpulver erhalten.

### Beispiel 4

### Herstellung eines Quaterpolymers mit 1,2-Dicarbonsäure-monotetrahydrofuranylester-Gruppierungen

4 GT Tetrahydrofuranyl-fumarat, 2 GT Maleinimid, und 2,5 GT 1-Hexen werden zusammen mit 5,7 GT Allyltrimethylsilan und 0,08 GT Azobisisobutyronitril in 15 GT Ethylacetat gelöst. Die Lösung wird 24 Stunden zum Sieden erhitzt und danach auf Raumtemperatur abgekühlt. Durch Eintropfen der Polymerlösung in Petrolether (Siedebereich 60 bis 80°C), anschließende Filtration und Trocknung bei 50°C für 24 Stunden im Vakuum werden 10,5 GT farbloses Polymerpulver erhalten.

## Patentansprüche

1. Filmbildendes, funktionalisiertes Polymer mit 1,2-Dicarbonsäurehalbester-Gruppierungen, **dadurch gekennzeichnet, daß** es einen säurelabilen, hydrolysestabilen Polymerbaustein (A) folgender Struktur: 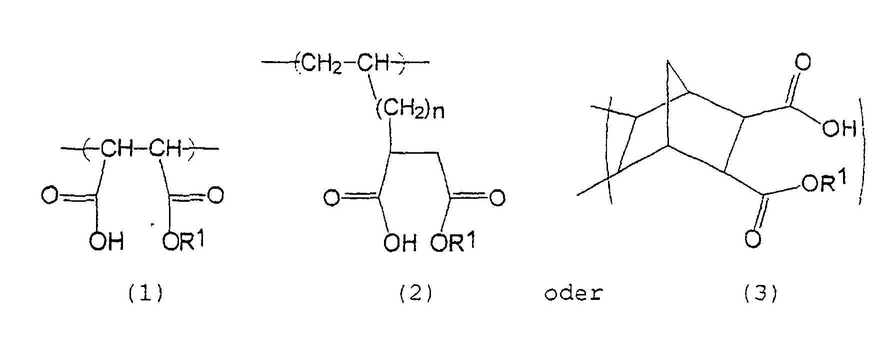 mit einem Anteil von 1 bis 99 Mol-% und einen thermisch stabilen Polymerbaustein (B) folgender Struktur: 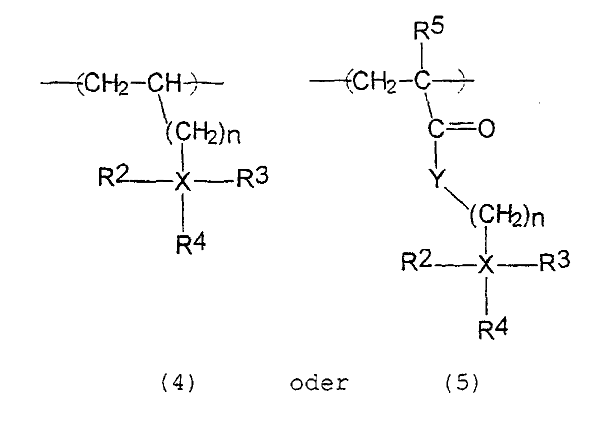 mit einem Anteil von 99 bis 1 Mol-% aufweist,
wobei folgendes gilt:
n = 0, 1, 2 oder 3,
R¹ ist ein über ein tertiäres C-Atom an das 0-Atom gebundener Kohlenwasserstoffrest mit insgesamt 4 bis 10 C-Atomen oder ein 2-Tetrahydrofuranyl- oder 2-Tetrahydropyranylrest,
R², R³ und R⁴ sind - unabhängig voneinander - C₁- bis C₆-Alkyl oder C₁- bis C₆-Alkoxy, C₆- bis C₁₈-Aryl oder C₆- bis C₁₈-Aryloxy oder Aralkyl mit einer C₆- bis C₁₈-Arylgruppe und einem C₁- bis C₄-Alkylenrest,
R⁵ ist H oder C₁- bis C₆-Alkyl,
X ist Si oder Sn,
Y ist O oder NH.

2. Polymer nach Anspruch 1, **dadurch gekennzeichnet, daß** der Anteil am Polymerbaustein (A) 5 bis 50 Mol-% beträgt.

3. Polymer nach Anspruch 1 oder 2, **dadurch gekennzeichnet, daß** es einen weiteren thermisch stabilen Polymerbaustein (C) folgender Struktur mit einem Anteil von 1 bis 50 Mol-% enthält: 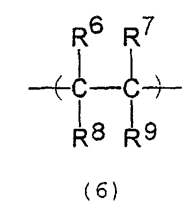 wobei folgendes gilt:
R⁶, R⁷, R⁸ und R⁹ sind - unabhängig voneinander - H, C₁- bis C₆-Alkyl, C₆- bis C₁₈-Aryl, Halogen, CN, Methoxyphenyl oder ein Rest folgender Struktur: 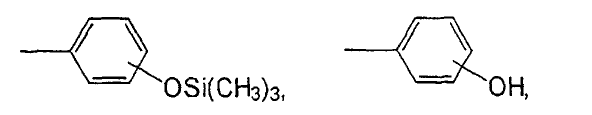 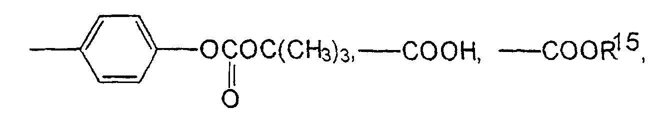
―CH₂Si(CH₃)₃, ―Si(CH₃)₃, ―Si(OCH₃)₃
wobei R¹⁵ die Bedeutung H, C₁- bis C₆-Alkyl, C₆- bis C₁₈-Aryl, CH₂=CH-, CH₂=CH-CH₂- oder CH₂=CH-CO- hat.

4. Polymer nach einem der Ansprüche 1 bis 3, **dadurch gekennzeichnet, daß** es zusätzlich einen reaktive Gruppen aufweisenden Polymerbaustein (D) folgender Struktur mit einem Anteil von 1 bis 50 Mol-% enthält: 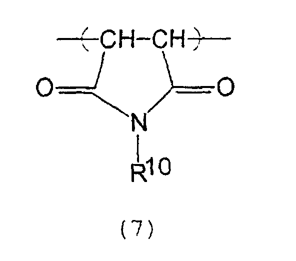 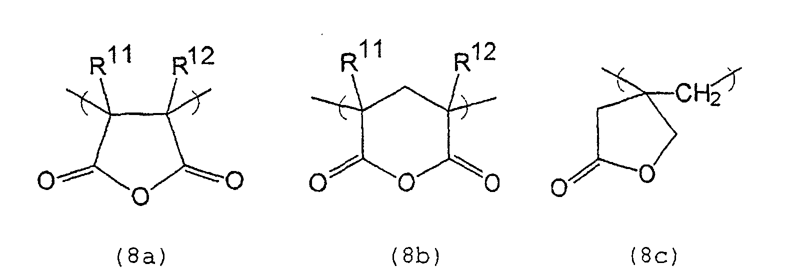 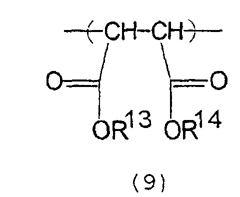 wobei folgendes gilt:
R¹⁰ ist H, C₁- bis C₆-Alkyl, C₂- bis C₆-Alkenyl, C₆- bis C₁₈-Aryl, Halogen oder halogensubstituiertes C₁- bis C₆-Alkyl,
R¹¹ und R¹² sind - unabhängig voneinander - lineares C₁- bis C₁₈-Alkyl,
R¹³ und R¹⁴ sind - unabhängig voneinander - lineares C₁- bis C₁₈-Alkyl oder tert.-Butyl.

## Claims

1. A film-forming, functionalized polymer having 1,2-dicarboxylic acid monoester groups, **characterized in that** it has an acid-labile, hydrolysis-stable polymer building block (A) of the following structure: 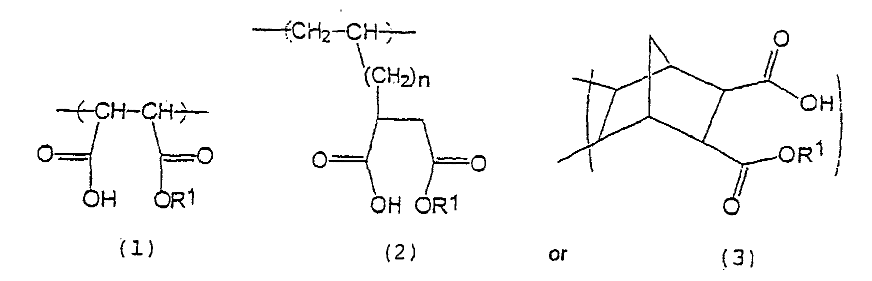 in an amount of from 1 to 99 mol% and a thermally stable polymer building block (B) of the following structure: 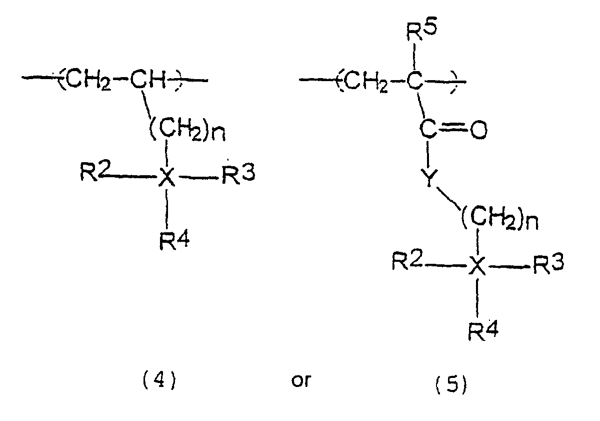 in an amount of from 99 to 1 mol%,
where the following is applicable:
n = 0, 1, 2 or 3,
R¹ is a hydrocarbon radical bonded via a tertiary C atom to the O atom and having a total of 4 to 10 C atoms or a 2-tetrahydrofuranyl or 2-tetrahydropyranyl radical,
R², R³ and R⁴ - independently of one another - are C₁- to C₆-alkyl or C₁- to C₆-alkoxy, C₆- to C₁₈-aryl or C₆- to C₁₈-aryloxy or aralkyl having a C₆- to C₁₈-aryl group and a C₁- to C₄-alkylene radical,
R⁵ is H or C₁- to C₆-alkyl,
X is Si or Sn,
Y is O or NH.

2. The polymer as claimed in claim 1, **characterized in that** the amount of the polymer building block (A) is from 5 to 50 mol%.

3. The polymer as claimed in claim 1 or 2, **characterized in that** it contains a further thermally stable polymer building block (C) of the following structure in an amount of from 1 to 50 mol%: 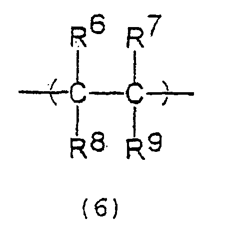 where the following is applicable:
R⁶, R⁷, R⁸ and R⁹ - independently of one another - are H, C₁- to C₆-alkyl, C6- to C₁₈-aryl, halogen, CN, methoxyphenyl or a radical of the following structure: 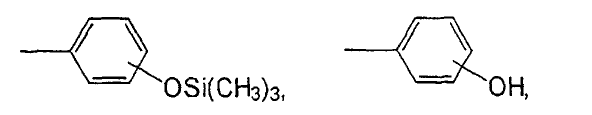 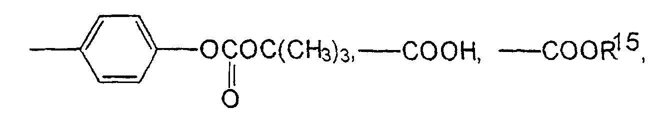
―CH₂Si(CH₃)₃, ―Si(CH₃)₃, ―Si(OCH₃)₃
where R¹⁵ is H, C₁- to C₆-alkyl, C6- to C₁₈-aryl, CH₂=CH-CH₂=CH-CH₂- or CH₂=CH-CO-.

4. The polymer as claimed in any of claims 1 to 3, **characterized in that** it additionally contains a polymer building block (D) having reactive groups and of the following structure in an amount of from 1 to 50 mol%: 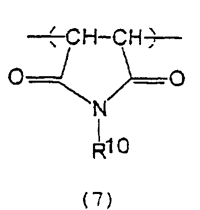 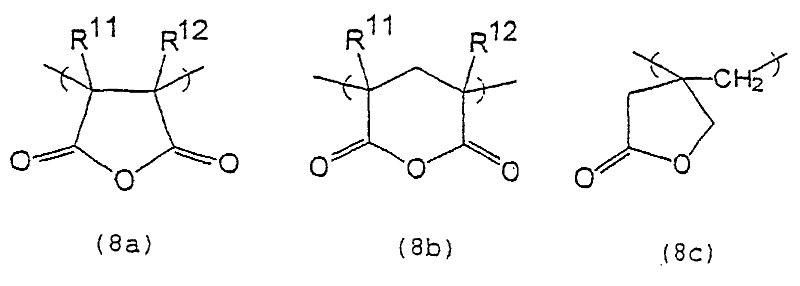 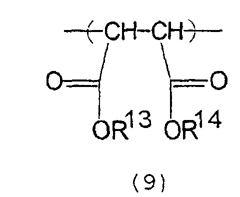 where the following is applicable:
R¹⁰ is H, C₁- to C₆-alkyl, C₂- to C₆-alkenyl, C₆- to C₁₈-aryl, halogen or halogen-substituted C₁- to C₆-alkyl,
R¹¹ and R¹² - independently of one another - are linear C₁- to C₁₈-alkyl,
R¹³ and R¹⁴ - independently of one another - are linear C₁- to C₁₈-alkyl or tert-butyl.

## Revendications

1. Polymère fonctionnalisé filmogène ayant des groupements hémi-ester d'acide 1,2-dicarboxylique, **caractérisé en ce qu'**il a un motif (A) de polymère labile sous l'effet d'un acide et stable à l'hydrolyse ayant la structure suivante : 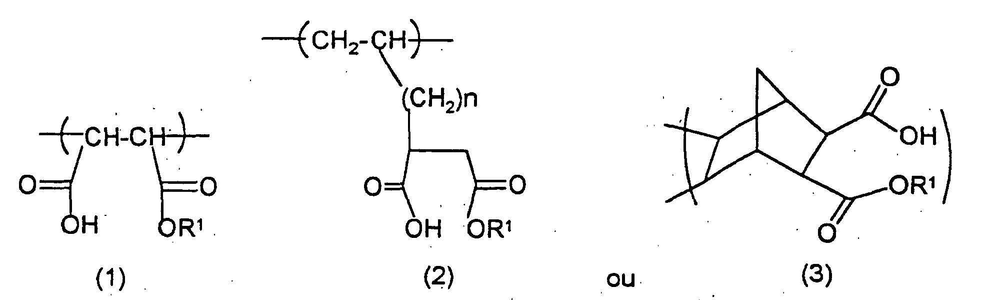 en une proportion de 1 à 99 % en mole et un motif (B) de polymère stable thermiquement ayant la structure suivante : 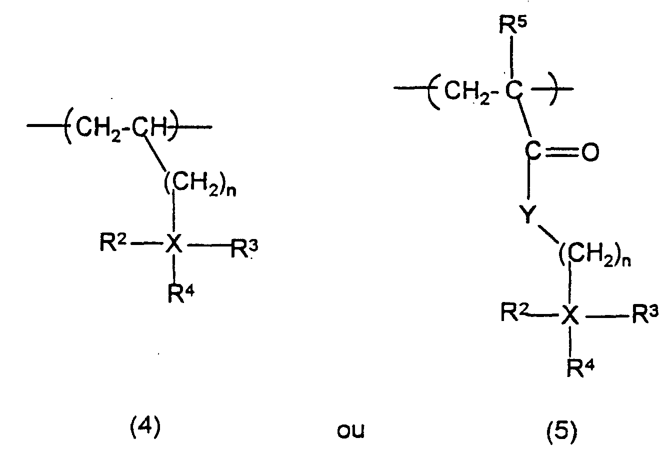 en une proportion de 99 à 1 % en mole,
dans lequel :
n = 0, 1, 2 ou 3,
R¹ est un radical hydrocarboné lié par l'intermédiaire d'un atome de carbone tertiaire à l'atome d'oxygène et ayant en tout de 4 à 10 atomes de carbone ou un radical 2-tétrahydrofuranyle ou un radical 2-tétrahydropyranyle,
R², R³ et R⁴ sont indépendamment les uns des autres, des radicaux alcoyle ayant de 1 à 6 atomes de carbone ou alcoxy ayant de 1 à 6 atomes de carbone, aryle ayant de 6 à 18 atomes de carbone ou aryloxy ou aralcoyle ayant de 6 à 18 atomes de carbone et ayant un groupe aryle ayant de 6 à 18 atomes de carbone et un radical alcoylène ayant de 1 à 4 atomes de carbone,
R⁵ est H ou alcoyle ayant de 1 à 6 atomes de carbone
X est Si ou Sn,
Y est O ou NH.

2. Polymère suivant la revendication 1, **caractérisé en ce que** la proportion de motif (A) de polymère va de 5 à 50 % en mole.

3. Polymère suivant la revendication 1 ou 2, **caractérisé en ce qu'**il contient un autre motif (C) de polymère stable thermiquement ayant la structure suivante en une proportion de 1 à 50 % en mole, dans lequel on a : 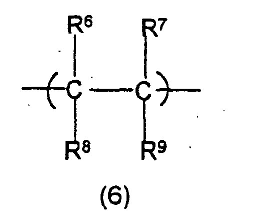 R⁶, R⁷, R⁸ et R⁹ sont, indépendamment les uns des autres, H, alcoyle ayant de 1 à 6 atomes de carbone, aryle ayant de 6 à 18 atomes de carbone, halogène, CN, méhoxyphényle ou un radical ayant la structure suivante : 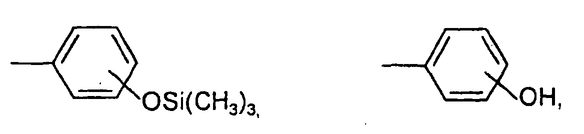 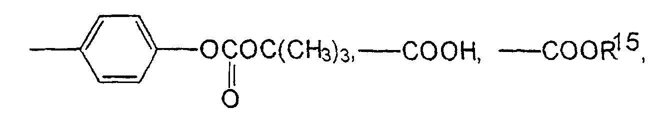
―CH₂Si(CH₃)₃, ―Si(CH₃)₃, ―Si(OCH₃)_{3,}
dans laquelle R¹⁵ signifie H, alcoyle ayant de 1 à 6 atomes de carbone, aryle ayant de 6 à 18 atomes de carbone, CH₂=CH-, CH₂=CH-CH₂- ou CH₂=CH-CO-.

4. Polymère suivant l'une quelconque des revendications 1 à 3, **caractérisé en ce qu'**il contient en outre un motif (D) de polymère présentant un groupe réactif ayant la structure suivante en une proportion de 1 à 50 % en mole : 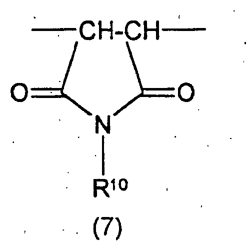 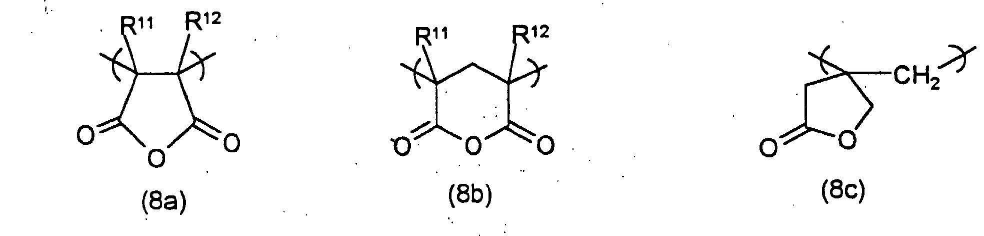 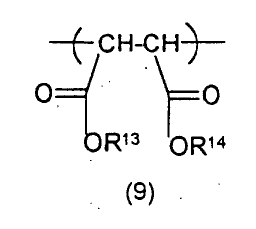 dans laquelle on a :
R¹⁰ est H, alcoyle ayant de 1 à 6 atomes de carbone, alcényle ayant de 2 à 6 atomes de carbone, aryle ayant de 6 à 18 atomes de carbone, halogène ou alcoyle ayant de 1 à 6 atomes de carbone et substitué par un halogène,
R¹¹ et R¹² sont indépendamment l'un de l'autre alcoyle linéaire ayant de 1 à 18 atomes de carbone,
R¹³ et R¹⁴ sont indépendamment l'un de l'autre alcoyle linéaire ayant de 1 à 18 atomes de carbone ou butyle tertiaire.
